# EUROPÄISCHE PATENTANMELDUNG

(11) **EP 1 279 559 A2**
(43) Veröffentlichungstag der Anmeldung: **29.01.2003**
(21) Anmeldenummer: 02015312.8
(22) Anmeldetag: 10.07.2002
(51) Int. Cl.: B60R 11/02

(54) **Akustisches und/oder visuelles Informationssystem, insbesondere für ein Kraftfahrzeug, und Verfahren zur Montage eines solchen Informationssystems**

(30) Priorität: 28.07.2001 DE 10136960
(71) Anmelder: ROBERT BOSCH GMBH, 70442 Stuttgart (DE)
(72) Erfinder: Koepsell, Martin, 30451 Hannover (DE)

(57) **Zusammenfassung**

Um ein akustisches und/oder visuelles Informationssystem, insbesondere für ein Kraftfahrzeug, mit einem mit elektrischen Kontaktierungen versehenen Frontbauteil und Verfahren zur Montage eines akustischen und/oder visuellen Informationssystems zu schaffen, mit denen eine kostengünstige Herstellung und Montage sowie ein gutes äußeres Erscheinungsbild des Informationssystems erreicht werden, ist erfindungsgemäß vorgesehen, dass eine Schalterplatte (3) mit dem Frontbauteil (1) mechanisch und elektrisch verbindbar ist, wobei das Frontbauteil (1) als ein Verbund-Bauteil mit mehreren Komponenten ausgebildet ist, von denen jeweils mindestens eine Komponente elektrisch leitend und eine Komponente elektrisch nichtleitend ist. Verfahrensgemäß ist vorgesehen, dass bei der Montage jeweils die Schalterplatte (3) und das Frontbauteil (1) sowie die Gerätekappe (7) und das Frontbauteil (1) derart miteinander verbunden werden, dass jeweils die Schalterplatte (3) mit dem Frontbauteil (1) und die Gerätekappe (7) mit dem Frontbauteil (1) in einem Arbeitgang gleichzeitig mechanisch verbunden und elektrisch kontaktiert werden.

## Beschreibung

### Technisches Gebiet

Die Erfindung betrifft ein akustisches und/oder visuelles Informationssystem, insbesondere für ein Kraftfahrzeug, und ein Verfahren zur Montage eines solchen Informationssystems mit den in den Oberbegriffen der Ansprüche 1 und 13 genannten Merkmalen.

### Stand der Technik

Es ist bekannt, den Frontbereich von akustischen und/oder visuellen Informationssystemen mit Gerätekappen zu versehen, in die Tasten und Wippen, Koronen für Drehknöpfe, Lichtleiter für CC/CD-Schächte, Flüssigkristallanzeigen (LCD), LCD-Lichtleiter, LCD-Reflektoren, Schaltmatten oder Tippschalter integriert sind. Über elektrische Kontaktierungen sind die entsprechenden Teile, die im Frontbereich der Informationssysteme angeordnet sind, mit einer hinter der Gerätekappe befindlichen Schalterplatte verbunden. Die Schalterplatte ist in der Regel als Trägerbauteil für Steckelemente ausgebildet, über die eine elektrische Verbindung mit einer Hauptplatte herstellbar ist. Die Gerätekappe wird an einer metallischen Frontplatte, die Bestandteil des Gehäuses des Informationssystems ist, befestigt. Das Informationssystem wird bei seiner Montage in eine, innerhalb einer Vertiefung der Armaturentafel befindliche Ausnehmung, die einen rechteckigen Querschnitt aufweist, eingeschoben. Zur Befestigung richtet man das Informationssystem innerhalb der Ausnehmung der Armaturentafel so aus, dass sich jeweils nach beiden Seiten sowie nach oben und nach unten ein gleichgroßer Spalt zwischen dem Informationssystem und den jeweils angrenzenden Bereichen der Armaturentafel ergibt.

Nachteilig bei diesen bekannten Lösungen des Standes der Technik ist insbesondere der hohe Aufwand an Bauelementen für die Herstellung des Informationssystems sowie dessen komplizierter Aufbau. Ein weiterer Nachteil besteht in einer Beeinträchtigung des äußeren Erscheinungsbildes des in die Armaturentafel eingebauten Informationssystems, die durch die konstruktiv bedingten Zwischenräume zwischen dem Informationssystem und der Armaturentafel verursacht wird. Des Weiteren wird durch den komplizierten Aufbau des Informationssystems der Einbau in die Armaturentafel erschwert.

### Darstellung der Erfindung, Aufgabe, Lösung, Vorteile

Es ist Aufgabe der vorliegenden Erfindung, ein akustisches und/oder visuelles Informationssystem sowie ein Verfahren zur Montage eines solchen Informationssystems der gattungsgemäßen Art zu schaffen, mit denen eine kostengünstige Herstellung und Montage sowie ein gutes äußeres Erscheinungsbild des Informationssystems erreicht werden.

Diese Aufgabe wird durch ein Informationssystem und ein Verfahren der oben genannten Art mit den in den Ansprüchen 1 und 13 gekennzeichneten Merkmalen gelöst.

Das erfindungsgemäße akustische und/oder visuelle Informationssystem, nachfolgend nur Informationssystem genannt, mit den im Anspruch 1 genannten Merkmalen bietet den Vorteil, dass das Frontbauteil durch seinen Aufbau die Funktion von mehreren einzelnen Bauteilen, die bisher notwendig waren, übernimmt. Dadurch, dass eine Schalterplatte mit dem Frontbauteil mechanisch und elektrisch verbindbar ist, wobei das Frontbauteil als ein Verbund-Bauteil mit mehreren Komponenten ausgebildet ist, von denen jeweils mindestens eine Komponente elektrisch leitend und eine Komponente elektrisch nichtleitend ist, wird in vorteilhafter Weise ein in seinem Aufbau einfach herzustellendes, kostengünstiges Frontbauteil eines Informationssystems geschaffen.

Das äußere Erscheinungsbild des in der Armaturentafel integrierten Informationssystems kann durch die Erfindung wesentlich verbessert werden, indem die im Designbereich der Armaturentafel liegenden sichtbaren Zwischenräume zwischen dem Informationssystem und der Armaturentafel sich auf ein unvermeidbares Mindestmaß verringern.

In einer bevorzugten Ausgestaltung der Erfindung ist das Frontbauteil als ein Molded Interconnect Device (MID)-Bauteil ausgebildet. Dabei ist in einer weiteren bevorzugten Ausgestaltung der Erfindung vorgesehen, dass das Frontbauteil ein Kunststoff-Metall-Verbundteil ist.

Eine andere bevorzugte Ausgestaltung der Erfindung sieht vor, dass in den Kunststoffteil des Frontbauteiles Leiterbahnen mit Kontaktelementen integriert sind. Diese Leiterbahnen werden gemäß einer weiteren bevorzugten Ausgestaltung der Erfindung durch ein Stanzgitter gebildet. Als Kontaktelemente sind am Frontbauteil Lötpins und Federkontakte angeordnet.

Das Frontbauteil mit den in den Kunststoffteil integrierten Leiterbahnen ersetzt zusammen mit der Schalterplatte vorteilhafterweise die metallische Frontplatte, einschließlich der gegebenenfalls notwendigen Kappenträger oder der Druckplatte, sowie die elektrischen Verbindungselemente. Dadurch wird der Aufwand an Bauelementen für die Fertigung und Montage des Informationssystems wesentlich reduziert und der Aufbau des Informationssystems insgesamt vereinfacht. Somit ergeben sich Kosteneinsparungen, die sowohl in der Fertigung als auch in der Montage des Informationssystems wirksam werden. Die elektrische Verbindung vom Frontbauteil zur Hauptplatte ist vorteilhafterweise ohne einen zusätzlichen Arbeitsgang herstellbar. Das als MID-Bauteil gefertigte Frontbauteil wird wie die bisherige Frontplatte auf die Hauptplatte bestückt und bei der standardmäßigen Wellenlötung mit der Hauptplatte elektrisch kontaktiert. Die elektrische Verbindung von der Frontplatte zur Hauptplatte kann auf diese Weise einfach, sicher und kostengünstig hergestellt werden. Durch die erfindungsgemäße Lösung wird außerdem die elektromagnetische Verträglichkeit des Informationssystems verbessert, da die EMV-Abschirmung direkt mit der Hauptplatte verlötet ist.

Das als MID-Bauteil gefertigte Frontbauteil erfüllt in vorteilhafter Weise sowohl elektrisch leitende als auch statische Funktionen, da es als Trägerteil mechanischen Beanspruchungen standhalten muss. Im Spaltbereich zur Armaturentafel auftretende Kräfte werden vorteilhafterweise auf direktem Wege in das Frontbauteil eingeleitet, ohne den Funktionsbereich der Gerätekappe negativ zu beeinflussen. Das erfindungsgemäße Informationssystem ermöglicht eine Verringerung der Spaltabmessungen zur Armaturentafel infolge der Vereinfachung der Montage. Die Lagefixierung des Informationssystems kann durch unmittelbares Ausrichten des Informationssystems am sichtbaren Spalt zur Armaturentafel vorgenommen werden. Der innerhalb der Armaturentafel für das Informationssystem benötigte Bauraum wird durch die Erfindung reduziert.

Insgesamt ergeben sich durch die erfindungsgemäße Lösung neue Gestaltungsmöglichkeiten für das Design des Informationssystems.

Das erfindungsgemäße Verfahren zur Montage eines akustischen und/oder visuellen Informationssystems mit den im Anspruch 13 genannten Merkmalen vereinfacht in vorteilhafter Weise die Montage des Informationssystems. Dadurch, dass bei der Montage jeweils die Schalterplatte und das Frontbauteil sowie die Gerätekappe und das Frontbauteil derart miteinander verbunden werden, dass jeweils die Schalterplatte mit dem Frontbauteil und die Gerätekappe mit dem Frontbauteil in einem Arbeitsgang gleichzeitig mechanisch verbunden und elektrisch kontaktiert werden, wird ein einfacher und zugleich passgenauer Einbau des Informationssystems in die Armaturentafel eines Kraftfahrzeuges ermöglicht.

Der besondere Vorteil besteht dabei darin, dass bei der Montage des Informationssystems die mit Tasten und Schaltmatte bestückte Gerätekappe auf einfache Weise mit dem Frontbauteil verbunden werden kann, indem die Gerätekappe auf das Frontbauteil geschnappt wird.

Weitere vorteilhafte Ausgestaltungen der Erfindung ergeben sich aus den in den Unteransprüchen genannten Merkmalen.

### Kurze Beschreibung der Zeichnungen

Nachstehend wird die Erfindung in einem Ausführungsbeispiel anhand der beigefügten Zeichnungen näher erläutert. Es zeigen:
- Fig. 1: eine Perspektivansicht eines Frontbauteiles mit einem integrierten Stanzgitter, wobei die Ansicht auf das Frontbauteil aus einer Perspektive von unten dargestellt ist;
- Fig. 2: eine Perspektivansicht eines vorgefertigten Stanzgitters mit Lötpins und Federkontakten;
- Fig. 3: eine Perspektivansicht eines Teiles eines Frontbauteiles mit hervorstehenden Federkontakten;
- Fig. 4: einen Vertikalschnitt durch ein Frontbauteil in der Darstellung als Perspektivansicht, wobei das Frontbauteil in Verbindung mit einer montierten Hauptplatte und einer Gerätekappe gezeigt wird und
- Fig. 5: einen Vertikalschnitt durch ein Frontbauteil in der Darstellung als Perspektivansicht, wobei das Frontbauteil in Verbindung mit einer montierten Schalterplatte, einer Hauptplatte und einer Gerätekappe gezeigt wird.

### Bester Weg zur Ausführung der Erfindung

In den fünf Figuren sind die einzelnen Teile und Baugruppen des erfindungsgemäßen Informationssystems schematisch und nur mit den für die Erfindung wesentlichen Bestandteilen dargestellt. Gleiche Teile und Baugruppen des Informationssystems sind in den Figuren mit gleichen Bezugszeichen versehen und werden in der Regel auch jeweils nur einmal beschrieben.

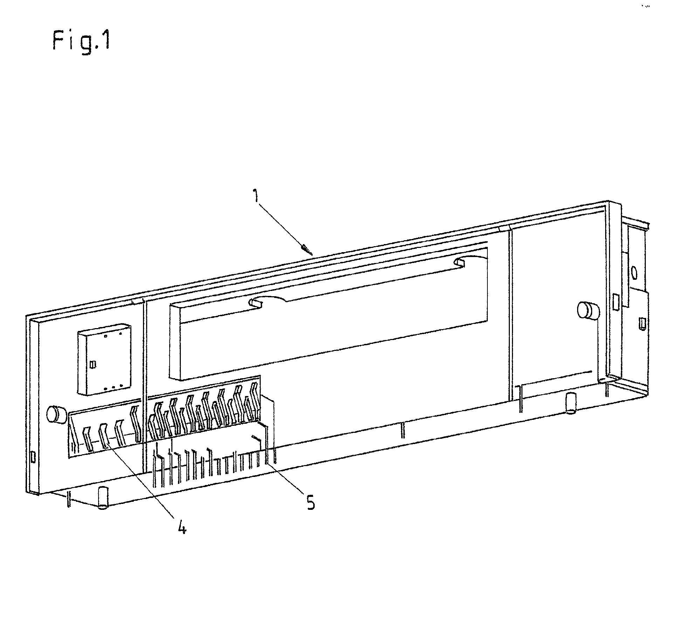

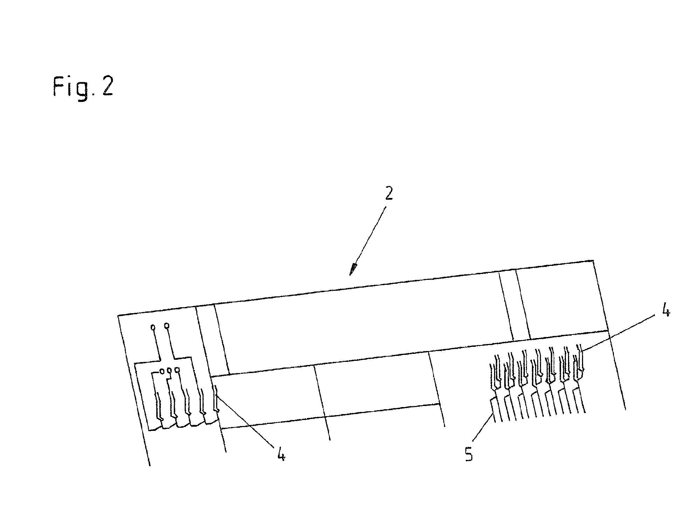

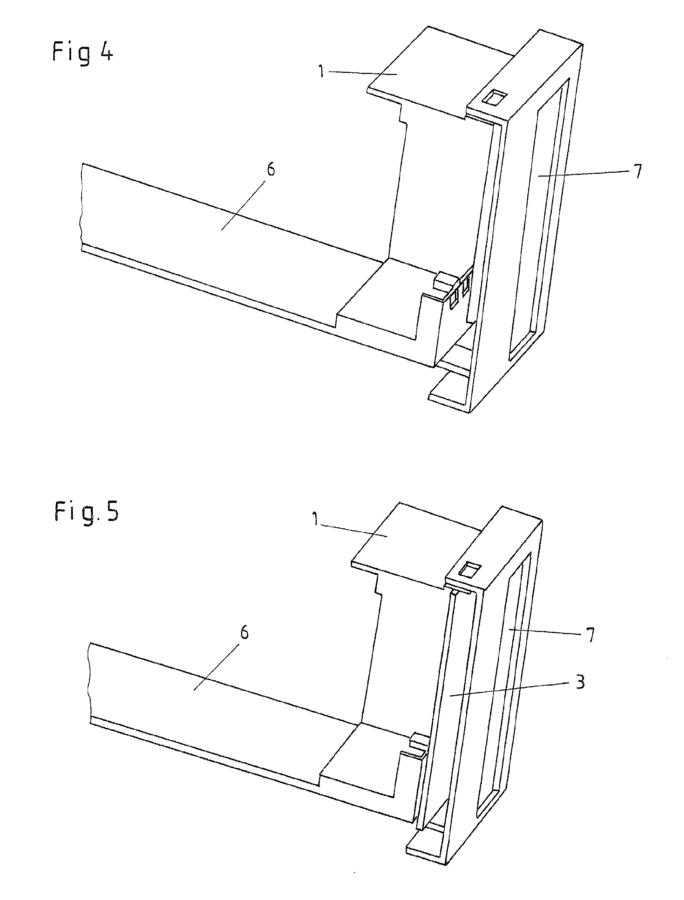

In Fig. 1 ist ein bevorzugtes Ausführungsbeispiel eines Frontbauteiles 100 des erfindungsgemäßen Informationssystems in einer Perspektivansicht dargestellt. Das Frontbauteil 100 stellt in Form eines Molded Interconnect Device (MID)-Bauteiles ein einheitliches Teil dar. Das Frontbauteil 100 wird vorzugsweise als ein Kunststoff-Metall-Verbundteil gefertigt. Das hierfür bevorzugt angewendete Spritzgussverfahren ermöglicht die Herstellung eines Frontbauteiles 100 mit vielfältigen Konfigurationen des Kunststoffteiles. Das Frontbauteil 100 kann somit in einer Vielzahl vorbestimmter Formen hergestellt werden. In den Kunststoffteil als nichtleitende Komponente des Frontbauteiles 100 sind in vorteilhafter Weise die metallischen Leiterbahnen mit Kontaktelementen integriert. Die Leiterbahnen als leitende Komponente des Frontbauteiles 100 werden dabei vorzugsweise durch ein Stanzgitter 2 (Fig. 2) gebildet. Die Kontaktelemente der Leiterbahnen sind in Form von Federkontakten 4 und Lötpins 5 ausgebildet. Die Federkontakte 4 dienen der Herstellung elektrischer Verbindungen vom Frontbauteil 100 zur Schalterplatte 3 (Fig. 5) und zum Encoder (nicht dargestellt). Über die Lötpins 5 wird das Frontbauteil 100 elektrisch durch Wellenlötung mit einer Hauptplatte 6 (Figuren 4 und 5) verbunden.

Zusätzlich ist das Frontbauteil 100 als Frontplatte der Audioanlage für den Designbereich der Armaturentafel 8 ausgebildet. Damit nimmt das Frontbauteil 100 gleichzeitig gestalterische und elektrisch leitende Funktionen in vorteilhafter Weise wahr.

Eine andere bevorzugte Ausgestaltung der Erfindung (nicht dargestellt) sieht vor, dass die Leiterbahnen des Frontbauteiles 100 durch eine elektrisch leitende Folie, die mit Kontaktgummis bestückt ist, gebildet wird. Zum Verbinden der Folie mit dem Frontbauteil 100 wird ein Prägeverfahren bevorzugt.

In Fig. 2 ist in einer Perspektivansicht ein an sich bekanntes Stanzgitter 2 als vorgefertigtes Einzelteil dargestellt. Das in Form einer Leiterplatte hergestellte Stanzgitter 2 weist in seinem unteren Endbereich eine bestimmte Anzahl von Kontaktelementen auf, die als Lötpins 5 der Herstellung elektrischer Verbindungen des Frontbauteiles 100 mit einer Hauptplatte 6 (Figuren 4 und 5) des Informationssystems dienen. Hierzu wird das Frontbauteil 100 auf die Hauptplatte 6 bestückt. Die Verbindung der Lötpins 5 mit der Hauptplatte 6 des Informationssystems erfolgt in an sich bekannter Weise durch Wellenlötung. Dabei wird die elektrische Verbindung des Frontbauteiles 100 mit der Hauptplatte 6 hergestellt. Dieser Lötprozess ist insbesondere vorteilhaft, da er ohnehin zur Verbindung anderer elektrischer Bauteile notwendig ist. Wie aus der Fig. 2 ersichtlich ist, sind die als Lötpins 5 ausgebildeten Kontaktelemente jeweils in zwei unterschiedlichen Ebenen angeordnet.

Die Leiterplatte verfügt neben den Lötpins über weitere Kontaktelemente, die in Form von Federkontakten 4 ausgebildet sind. Die Federkontakte 4 dienen der Herstellung elektrischer Verbindungen mit der Schalterplatte 3 sowie mit dem Encoder des Informationssystems. In der Darstellung gemäß Fig. 2 sind die Federkontakte 4 zur Herstellung elektrischer Verbindungen mit der Schalterplatte 3 im rechten Teilbereich des Stanzgitters 2 und die Federkontakte 4 zur Herstellung elektrischer Verbindungen mit dem Encoder im linken Teilbereich des Stanzgitters 2 angeordnet.

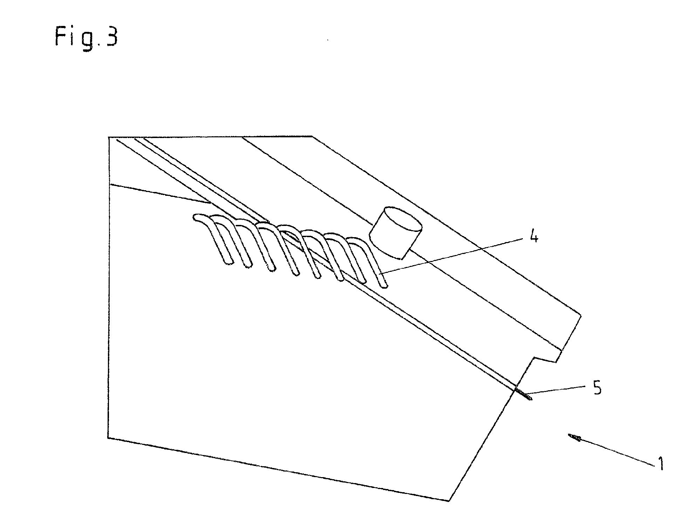

Die Fig. 3 zeigt die Anordnung der Federkontakte 4 an einem Frontbauteil 100, die mit Kontaktflächen der Schalterplatte 3 kontaktierbar sind. Das in Form einer Leiterplatte vorgefertigte Stanzgitter 2 ist innerhalb des Frontbauteiles 100 größtenteils in Kunststoff, der gute Eigenschaften als nichtleitendes Material besitzt, eingebettet und als solches nicht sichtbar. Die der Kontaktierung mit der Schalterplatte 3 des Informationssystems dienenden Federkontakte 4 weisen eine gebogene Form auf und ragen in einer vertikalen Anordnung nach hinten aus dem Frontbauteil 100 heraus. Die der Kontaktierung mit der Hauptplatte 6 des Informationssystems dienenden Lötpins 5 ragen in einer vertikalen Anordnung nach unten aus dem Frontbauteil 100 heraus.

Die Fig. 4 zeigt das Frontbauteil 100, in Verbindung mit einer Hauptplatte 6 und einer Gerätekappe 7, in einem Vertikalschnitt. Das Frontbauteil 100 steht an seinem unteren Ende mit der Hauptplatte 6 in Verbindung, die in dem Informationssystem waagerecht angeordnet ist. Elektrisch ist das Frontbauteil 100 mit der Hauptplatte 6 über die Lötpins 5 (Fig. 2) verbunden, die hier nicht sichtbar sind. Die Gerätekappe 7 ist in an sich bekannter Weise mit Tasten und Schaltmatten bestückt, die hier nicht dargestellt sind. Das Frontbauteil 100 und die Gerätekappe 7 sind so gestaltet, dass eine Verbindung beider Teile 100, 7 durch einfaches Aufschnappen der Gerätekappe 7 auf das Frontbauteil 100 hergestellt wird.

In der Fig. 5 ist das Frontbauteil 100, in Verbindung mit der Schalterplatte 3, der Hauptplatte 6 und der Gerätekappe 7, in einem Vertikalschnitt dargestellt. Die Schalterplatte 3 ist mit dem Frontbauteil 100 vorzugsweise durch eine Schnappverbindung mechanisch verbindbar. Die elektrische Verbindung beider Teile 100, 3 erfolgt über die am Frontbauteil 100 angeordneten Federkontakte 8, die im montierten Zustand der Schalterplatte 3 mit an der Rückseite der Schalterplatte 3 angeordneten Kontaktflächen kontaktieren. Des Weiteren stehen die Federkontakte des Frontbauteiles 100 mit einem Encoder (nicht dargestellt) in elektrischer Verbindung. Der Einbau des Informationssystems in die Armaturentafel des Kraftfahrzeuges erfolgt in der Weise, dass die Gerätekappe 7 nach vorne vorteilhafterweise in einer Ebene einen gleichmäßigen Abschluss mit der Armaturentafel bildet. Seitlich wird das Frontbauteil 100 mit der Gerätekappe 7 zum Einbau des Informationssystems so ausgerichtet, dass sich jeweils ein gleichgroßer Spalt zwischen der Gerätekappe 7 und der Armaturentafel nach beiden Seiten sowie nach oben und unten ergibt. Die Erfindung ermöglicht eine einfache Montage des Informationssystems vom Innenraum des Fahrzeuges her, da ein unmittelbares Ausrichten des Informationssystems innerhalb der Armaturentafel vorgenommen werden kann. Die jeweils als Spalt sichtbaren Zwischenräume zwischen der Gerätekappe 7, dem Informationssystem und der Armaturentafel sind dabei auf ein notwendiges Mindestmaß reduziert. Dadurch ist das gesamte Erscheinungsbild des von der Armaturentafel aufgenommenen erfindungsgemäßen Informationssystems gegenüber herkömmlichen Informationssystemen wesentlich verbessert.

Die Erfindung ist nicht allein auf die beschriebenen und dargestellten Ausführungsbeispiele beschränkt, sondern es sind technisch weitere Ausführungsformen eines Informationssystems möglich, die im Rahmen der Erfindung liegen.

### BEZUGSZEICHENLISTE

- 100: Frontbauteil
- 2: Stanzgitter
- 3: Schalterplatte
- 4: Federkontakt
- 5: Lötpin
- 6: Hauptplatte
- 7: Gerätekappe

## Patentansprüche

1. Akustisches und/oder visuelles Informationssystem, insbesondere für ein Kraftfahrzeug, mit einem mit elektrischen Kontaktierungen versehenen Frontbauteil,
**dadurch gekennzeichnet, dass**
eine Schalterplatte (3) mit dem Frontbauteil (100) mechanisch und elektrisch verbindbar ist, wobei das Frontbauteil (100) als ein Verbund-Bauteil mit mehreren Komponenten ausgebildet ist, von denen jeweils mindestens eine Komponente elektrisch leitend und eine Komponente elektrisch nichtleitend ist.

2. Akustisches und/oder visuelles Informationssystem nach Anspruch 1,
**dadurch gekennzeichnet, dass**
das Frontbauteil (100) vorzugsweise als ein Molded Interconnect Device (MID)-Bauteil ausgebildet ist.

3. Akustisches und/oder visuelles Informationssystem nach den Ansprüchen 1 und 2,
**dadurch gekennzeichnet, dass**
das Frontbauteil (100) vorzugsweise ein Kunststoff-Metall-Verbundteil ist.

4. Akustisches und/oder visuelles Informationssystem nach den Ansprüchen 1 bis 3,
**dadurch gekennzeichnet, dass**
in den Kunststoffteil des Frontbauteiles (100) Leiterbahnen mit Kontaktelementen integriert sind.

5. Akustisches und/oder visuelles Informationssystem nach den Ansprüchen 1 bis 4,
**dadurch gekennzeichnet, dass**
das Frontbauteil (100) vorzugsweise im Spritzgussverfahren herstellbar ist.

6. Akustisches und/oder visuelles Informationssystem nach Anspruch 4,
**dadurch gekennzeichnet, dass**
die Leiterbahnen des Frontbauteiles (100) vorzugsweise durch ein Stanzgitter (2) gebildet werden.

7. Akustisches und/oder visuelles Informationssystem nach Anspruch 4,
**dadurch gekennzeichnet, dass**
die Kontaktelemente Lötpins (5) und Federkontakte (4) sind.

8. Akustisches und/oder visuelles Informationssystem nach Anspruch 7,
**dadurch gekennzeichnet, dass**
die Lötpins (5) an dem Frontbauteil (100) nach unten hervorstehend angeordnet und mit einer Hauptplatte (6) durch Wellenlötung verbindbar sind.

9. Akustisches und/oder visuelles Informationssystem nach den Ansprüchen 1 und 7,
**dadurch gekennzeichnet,**
**dass** die Federkontakte (8) mit Kontaktflächen der Schalterplatte (3) elektrisch verbindbar sind.

10. Akustisches und/oder visuelles Informationssystem nach Anspruch 1,
**dadurch gekennzeichnet, dass**
die Schalterplatte (3) mit der Frontplatte durch eine Schnappverbindung mechanisch verbindbar ist.

11. Akustisches und/oder visuelles Informationssystem nach Anspruch 4,
**dadurch gekennzeichnet, dass**
die Leiterbahnen des Frontbauteiles (100) vorzugsweise durch eine elektrisch leitende Folie, die mit Kontaktgummis bestückt ist, gebildet werden.

12. Akustisches und/oder visuelles Informationssystem nach Anspruch 11,
**dadurch gekennzeichnet, dass**
die elektrisch leitende Folie vorzugsweise durch ein Prägeverfahren mit dem Frontbauteil (100) verbindbar ist.

13. Verfahren zur Montage eines akustischen und/oder visuellen Informationssystems, insbesondere eines akustischen und/oder visuellen Informationssystems nach einem der vorhergehenden Ansprüche,
**dadurch gekennzeichnet, dass**
bei der Montage jeweils die Schalterplatte (3) und das Frontbauteil (100) sowie die Gerätekappe (7) und das Frontbauteil (100) derart miteinander verbunden werden, dass jeweils die Schalterplatte (3) mit dem Frontbauteil (100) und die Gerätekappe (7) mit dem Frontbauteil (100) in einem Arbeitgang gleichzeitig mechanisch verbunden und elektrisch kontaktiert werden.

14. Verfahren nach Anspruch 13,
**dadurch gekennzeichnet, dass**
bei der Montage vorzugsweise jeweils die Schalterplatte (3) auf das Frontbauteil (100) und die Gerätekappe (7) auf das Frontbauteil (100) geschnappt werden.
